(19) **Europäisches Patentamt**

**European Patent Office**

**Office européen des brevets**

(11) **EP 1 564 792 A2**

(12) **EUROPEAN PATENT APPLICATION**

(43) Date of publication:
17.08.2005 Bulletin 2005/33

(51) Int Cl.⁷: **H01L 21/00**

(21) Application number: **05075151.0**

(22) Date of filing: **20.01.2005**

(84) Designated Contracting States:
**AT BE BG CH CY CZ DE DK EE ES FI FR GB GR HU IE IS IT LI LT LU MC NL PL PT RO SE SI SK TR**
Designated Extension States:
**AL BA HR LV MK YU**

(30) Priority: **13.02.2004 EP 04100567**

(71) Applicant: **Assembléon N.V.**
**5503 LA Veldhoven (NL)**

(72) Inventors:
• **Petit, Rita Marguerite Albin Lambertine**
  **5646 KR Eindhoven (NL)**
• **De Bock, A., Building HVR**
  **5503 LA Veldhoven (NL)**
• **Verbakel, J.M.M., Building HVR**
  **5503 LA Veldhoven (NL)**

(74) Representative:
**Dohmen, Johannes Maria Gerardus et al**
**Algemeen Octrooi- en Merkenbureau**
**P.O. Box 645**
**5600 AP Eindhoven (NL)**

(54) **Method and device for estimating a component placement position on a substrate**

(57)    A method and a device for estimating at least one component placement position on a substrate (5) at which a component (3) is to be placed, wherein the component placement position is estimated (6) on the basis of the position of at least one mark (8) on the substrate (5), characterized in that

- statistical measurement inaccuracies of the marks (8) are determined,
- after which the positional accuracy of the component placement position (6) on the substrate (5) is estimated on the basis of the measurement inaccuracies of the marks (8),

- subsequently the estimated positional accuracy of the component placement position (6) is compared with a predetermined, desired positional accuracy,
- after which it is decided whether or not the component (3) is to be placed on the substrate (5) with the estimated positional accuracy of the component placement position (6).

**Description**

The invention relates to a method for estimating at least one component placement position on a substrate at which a component is to be placed, wherein the component placement position is estimated on the basis of the position of at least one mark on the substrate.

The invention also relates to a device suitable for carrying out such a method.

With such a method, which is known from EP-A1-0 042 977, positions of a number of marks on a substrate are measured and compared with the expected positions of the marks. Based on the differences between the measured positions and the expected positions of the marks, a transformation is applied to the expected or theoretical component placement positions on the substrate at which components are to be placed.

In this way corrections are made for errors that occur as a result of, for example, misalignment of a substrate in a component placement device, stretch of the substrate, etc.

The last few decades the components to be placed have become smaller and smaller, and these components must be positioned on the substrate with ever higher precision. If the component placement position is determined relatively inaccurately, this will lead to incorrect placement of the component at the component placement position, resulting in a substrate that will be rejected in the course of a subsequent process.

The object of the invention is to provide a method which makes it possible to estimate the accuracy of the placement of a component at a component placement position on the substrate.

This object is accomplished with the method according to the invention in that

- statistical measurement inaccuracies of the marks are determined,
- after which the positional accuracy of the component placement position on the substrate is estimated on the basis of the measurement inaccuracies of the marks,
- subsequently the estimated positional accuracy of the component placement position is compared with a predetermined, desired positional accuracy,
- after which it is decided whether or not the component is to be placed on the substrate with the estimated positional accuracy of the component placement position.

For example, upon determination of the position of the marks on a substrate in a component placement device by means of an optical camera, measurement inaccuracies occur, which can be statistically determined. With the method according to the invention, the positional accuracy of each component placement position is estimated on the basis of the statistical measurement inaccuracies of each mark and compared with a predetermined, desired positional accuracy. In this way it is possible to make an estimate of the probability that the component will be placed at the desired component placement position prior to the placement of a component at a component placement position. If the estimated positional accuracy is lower than the predetermined, desired positional accuracy, additional measures may be taken to ensure that the component will nevertheless be placed at the component placement position with a desired degree of accuracy.

If the estimated positional accuracy is significantly higher than the predetermined, desired positional accuracy for a number of component placement positions, whereas the estimated positional accuracy is lower than the desired positional accuracy for a number of other component placement positions, it may be decided, for example, to use other signs on the substrate as marks, relative to which newly selected marks, if possible, the estimated positional accuracy of all component placement positions is higher than the desired positional accuracy.

In this way it is possible to estimate the chance of a component being incorrectly placed at a component placement position already before said placement takes place, and to minimise said chance by taking additional measures.

One embodiment of the method according to the invention is characterized in that at least one other mark is selected if the estimated positional accuracy is lower than the desired positional accuracy, as a result of which the estimated positional accuracy becomes higher than the desired positional accuracy.

By selecting at least one other mark, relative to which the estimated positional accuracy is higher than the desired positional accuracy, it becomes possible to take measures to avoid the risk of a component being incorrectly placed at a component placement position already before placement of a component at the component placement position takes place, thus avoiding the risk of a component being incorrectly placed at a component placement position.

Another embodiment of the method according to the invention is characterized in that the estimated positional accuracy is communicated to a user if the estimated positional accuracy is lower than the desired positional accuracy.

In this way, the user of a component placement device in which such a method can be implemented will be able to adjust the positional accuracy for each component placement position, if desired, or pay extra attention afterwards when checking whether the desired accuracy has been realised.

Yet another embodiment of the method according to the invention is characterized in that the component placement position is determined by means of at least one mark located relatively close to the component placement position if the estimated positional accuracy is lower than the desired positional accuracy.

If the desired positional accuracy is relatively high, it may be necessary to determine for that particular component placement position the position relative to a mark that is located relatively close to the component placement position. Said mark may also be the component placement position itself, if desired.

Yet another embodiment of the method according to the invention is characterized in that the position(s) of the mark(s) as well as the component placement positions on the substrate are selected on the basis of the expected inaccuracies in the measurement of marks, the statistically determined inaccuracies that occur upon alignment of a component in a component placement device and the statistically determined inaccuracies that occur upon placement of the component on the substrate, in such a manner that the desired positional accuracy is lower than the estimated positional accuracy for each component placement position.

In this way adjustments are made not only for the expected inaccuracies in the measurement of marks, but also for other inaccuracies in a component placement machine, which are to be statistically determined, upon estimation of the positional accuracy of component placement positions, as a result of which the positional accuracy of the component placement positions can be determined with a relatively high degree of accuracy. If the desired positional accuracies are higher than the estimated positional accuracies, the positions of the marks and also of the component placement position on the substrate can be adjusted before the component is placed on the substrate and, if desired, even before the design of the substrate is made.

The invention will now be explained in more detail with reference to figures of a drawing and also with reference to formulae on a formula sheet.

In the drawing:

Fig. 1 shows a perspective view of a component placement device provided with a device according to the invention;

Fig. 2 shows a number of different signs suitable for use as marks for a substrate; and

Figs. 3A-3C show diagrams of estimated inaccuracies for, respectively, a substrate comprising two marks sensed by the component placement device without anisotropy occurring, a substrate comprising three marks and a substrate comprising two marks sensed by the component placement device with anisotropy occurring.

Like parts are indicated by the same numerals in the figures.

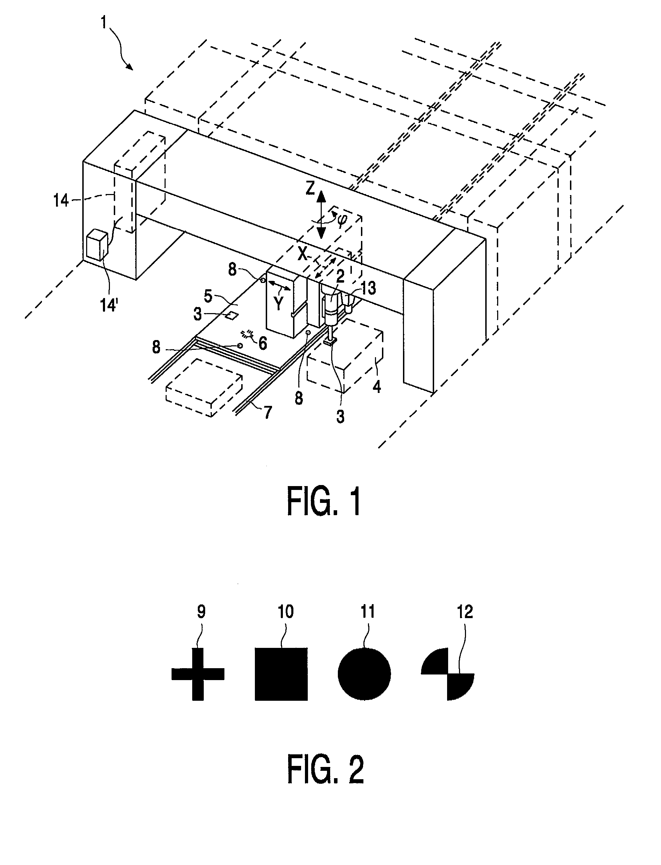

Fig. 1 shows a component placement device 1 comprising a component pickup unit 2 that is movable in X-direction and in Y-direction, by means of which a component 3 can be moved from a component supply unit 4 to a desired component placement position 6 on a substrate 5. The substrate 5 is carried through the component placement device 1 in the X-direction by means of a transport guide 7. To determine the position of the substrate 5 with respect to the transport guide 7 and with respect to the component pickup device 2, the substrate is provided with a number of marks 8. Said marks 8 may be in the form of, for example, a cross 9, a square 10, a circle 11, or part of a circle 12 as shown in Fig. 2. The number of marks 8 is preferably two or three, although a larger or a smaller number of marks will be used in some cases. The marks 8 are sensed by means of a camera 13 disposed beside the component pickup unit 2, after which the positions of the marks 8 relative to the component placement unit 2 are calculated on the basis of the images recorded by means of the camera 13. A processor 14 present in the device 1 is used for this purpose. Also the expected positions of the marks 8 relative to the component placement unit 2 can be determined by means of the processor 14. In addition, component placement positions at which components are to be placed are stored in the processor 14. The component placement positions can be determined in relation to the positions of the marks 8 in the processor 14. Subsequently, the processor 14 determines the component placement positions relative to the component placement unit 2 on the basis of the measured positions of the marks, after which a desired component 3 is placed at the component placement position 6 in question by means of the component placement unit 2. The component placement device 1 as described so far is known per se and will not be explained in more detail herein, therefore.

The component placement device 1 is provided with a device according to the invention for determining, prior to the placement of components 3 on the substrate 5, whether it is possible to realise the desired positional accuracy of the component placement position 6. The device comprises the processor 14 as well as an input unit 14' for inputting statistical data regarding measurement inaccuracies of the marks 8. Whether the desired positional accuracy can be realised and a component can be placed at the component placement position 6 with a sufficient degree of accuracy depends, among other things, on the accuracy with which the positions of the marks 8 can be determined, the accuracy with which the component 3 can be aligned with respect to the component placement unit 2 and the camera 13, the accuracy with which the component 3 is transported from the component supply device 4 to the component placement position 6, machine wear, vibrations, etc.

Using the method and the device according to the invention, an estimate of the positional accuracy of the component placement position 6, and consequently of the accuracy with which a component can be positioned at said component placement position is made before placement of the component takes place.

Model for inaccuracies in the positions of marks when three marks are used:

In the situation in which three marks will be sensed by means of the camera 13, the model of the deformation and the movement of the substrate 5 and the marks 8 present thereon that can be used for transforming the measured positions of the marks 8 relative to the expected positions of the marks 8 is linear. The errors in the determination of the position of the marks 8 by means of the camera 13 are exactly reproduced for each mark by means of said model.

The position Q of a random component placement position 6 can be written in terms of the positions of the marks 8 by means of formula A. In said formula A, Q is the position of the component placement position 6 and P0, P1 and P2 are the positions of the three marks 8.

The positional accuracy $S_Q$ can be derived by means of the error propagation formula as described in, for example, the book Mathematical Statistics and Data Analysis by J.A. Rice. On the basis of this formula, it can be determined that the statistical error $s_a$ in the position Q of the component placement position 6 equals formula B. In said formula, $s_{pi}$ is the s-value of the statistical measurement inaccuracy of mark i. Each mark i has its own $s_{pi}$-value, determined by measuring one and the same mark i on a number of different similar substrates 5.

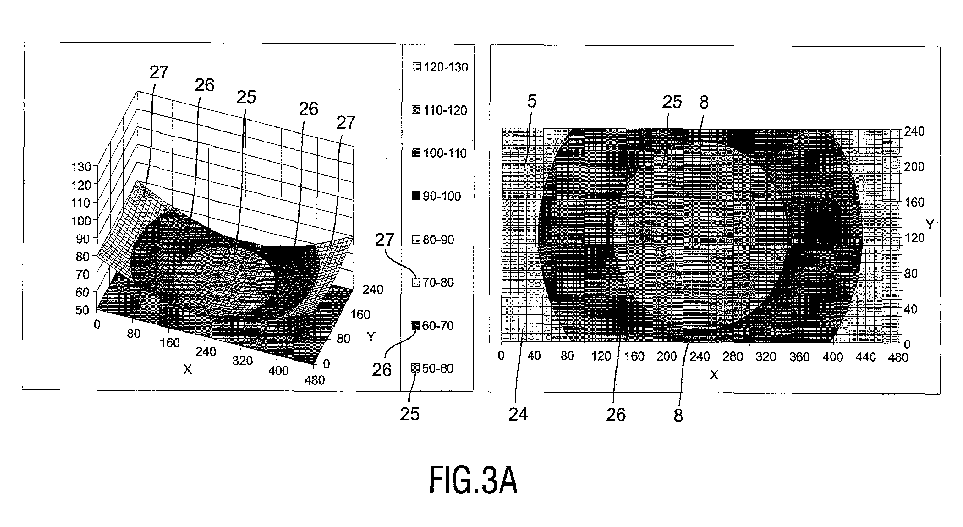

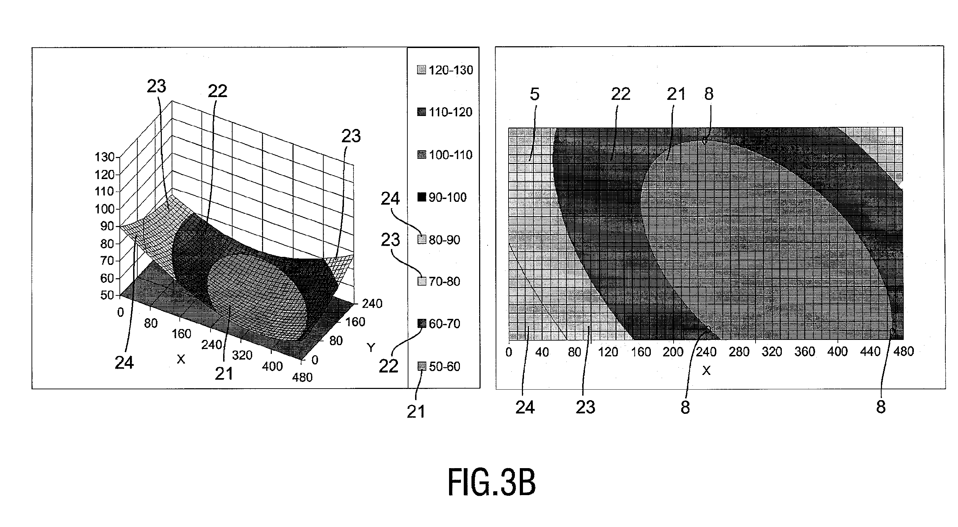

Fig. 3B shows two examples of diagrams, in three-dimensional view and two-dimensional view, respectively, in which the estimated positional accuracy is shown for an entire substrate 5. It is apparent from said figure that the positional accuracy is 50-60 μm in the region defined by the marks 8, that the positional accuracy is 60-70 μm in a surrounding region 22 and that the positional accuracy is 70-80 μm in the region surrounding said region 22, whilst the positional accuracy is 80-90 μm in the left-hand bottom corner 23 of the substrate 5. By means of the processor 14 that forms part of the device according to the invention it is determined whether the desired positional accuracies of the component placement positions in the regions 21-24 are higher or lower than the expected positional accuracies in the regions 21-24.

If the estimated positional accuracy is lower than the desired positional accuracy for a particular component placement position, a number of solutions are possible. If the desired positional accuracy for the component placement position in question cannot be realised for the specific substrate, the available marks and the available the component placement device and the selected model, the user can be alerted to this and the realised positional accuracy can be checked afterwards. In those cases in which the desired accuracy has not than realised, the substrate can be corrected manually.

It is also possible to use other signs on the substrate 5 as marks 8. Said signs may be fiducial marks specifically provided on the substrate 5 for that purpose, as shown in Fig. 2, for example. It is also possible, however, to use parts of the conductor pattern that is present on the substrate 5.

Furthermore it is possible to record a separate image of the region near a component placement position or of a component placement position by means of the camera 13, for example for a specific component placement position at which a component is to be placed with a very high degree of precision, on the basis of which image subsequently the location of the component placement position relative to the component placement unit 2 is determined. This is time-consuming, however, and will only be desirable for a limited number of components that are to be placed with a relatively high degree of precision.

In the method as described above, it is not only the measurement inaccuracies that occur upon measurement of the positions of the marks that have been taken into account. According to the method, the overall component placement accuracy $CPA_Q$ at component placement position 6 (position Q) is determined by means of formula C. In said formula, FIX indicates an error which, as can be determined from measurements of a respective component placement device, occurs with all components. Such an error is caused by calibration errors, for example. The letters OTH indicate errors that are specific for a particular component and a particular component placement position Q, which errors OTH dependend on the alignment of a component 3 with respect to the component pickup unit 2, for example, as well as the statistically determined errors that occur when the component 3 is being moved from the component supply device 4 to the component placement position 6.

Model for inaccuracies in the positions of marks when three marks are used:

Although it is preferable to use three marks, only to marks are present on a substrate 5 in some cases, which marks can be sensed by means of a camera 13. The position Q of the component placement position 6 is now expressed in terms of the positions $P_o$ and $P_i$ of the two marks 8 according to formula D. It is assumed in this connection that the transformation can be modelled by linear transformations, and that the fit of the transformation equals the measured positions of the marks.

On the basis of the error propagation formula it can be derived that the statistical errors in the position Q of the component placement position 6 are obtained by formula E. Assuming that the X-value and the Y-value of the statistical errors of the marks 8 are equal, it is obtained that the statistical errors or statistical measurement inaccuracies of each mark are as indicated in formula F.

Fig. 3B shows a three-dimensional and a two-dimensional diagram of the estimated positional accuracy over an entire substrate 5, which substrate 5 is provided with two marks 8. In a region 25 between the marks 8, the positional accuracy of the component placement positions is 50-60 μm, for example. In a region 26 surrounding said region 25, the accuracy is 60-70 μm, whilst in a region 27 surrounding said region 26 the positional accuracy is 70-80 μm. On the basis of these diagrams it can already be determined by means of the processor 14 whether it is possible to realise the desired positional accuracy at all positions on the substrate 5.

In the above, no allowance has been made yet for a possible anisotropic error that occurs in the case of anisotropic stretch between the substrate and the component placement device 1, wherein the amount of stretch $S_x$ in the X-direction does not equal the amount of stretch $S_y$ in the Y-direction. Anisotropy $j_x$, $j_y$ may also occur in the case of a rotated position of the substrate 5 relative to the X-Y coordinate system of the component placement device 1, if the substrate has deformed to the shape of a parallelogram in comparison with an expected rectangular shape of the substrate. In order to model the anisotropic error, it is possible, for example, to calculate the difference between the outcome of an actual anisotropic transformation and the transformation of the isotropic model. To calculate the anisotropic error in the position Q of the component placement position 6, it is assumed that the transformations have been modelled by linear transformation and that the outcome of the transformation for marks equals the measured positions of the marks 8. For calculating the anisotropic error it is stated in this model that the measurement inaccuracies of the marks 8 equal zero. The anisotropic error AnisQ can then be determined by means of formula G. In formula G, $F_x$ and $F_y$ are the X-portion and the Y-portion, respectively, of the normalised difference vectors of the two marks: $P_1$ - $P_0$. b represents the distance from the position Q to the line between the two marks 8. h22, h11, h12 and h21 are the elements of the transformation matrix H for transforming the expected positions of the marks 8 to the measured positions of the marks 8.

As is apparent from formula G, the anisotropic error at position Q is linear with the distance b to the line through the marks 8. The anisotropic error can be estimated by removing second-order terms by making use of the stretch anisotropy $s_y$-$s_x$ and the rotation anisotropic $j_y$ - $j_x$, which anisotropic error $Anis_Q$ is shown in formula H. The absolute value of the anisotropic error is shown in formula J.

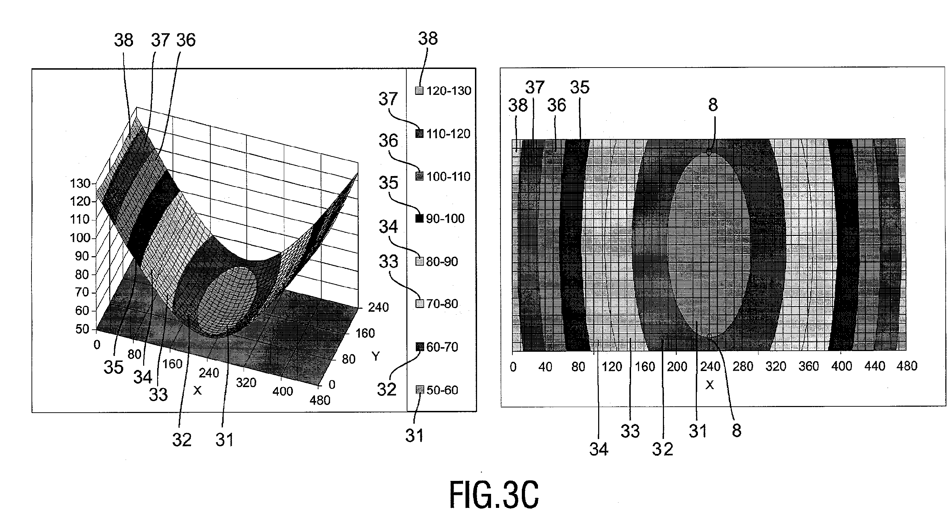

Fig. 3C shows a three-dimensional and a two-dimensional diagram, in which the expected positional inaccuracies are plotted for a substrate 5 that has undergone anisotropic stretching with respect to the component placement device 1, wherein $j_x = j_y = 0$ and $s_x = s_y = 0.0004$. As the diagram shows, a positional accuracy of 50-60 μm can be realised in the region 31 bounded by the marks 8, whereas a positional accuracy not higher than 120-130 μm can be realised in the region 38 located furthest away from the marks 8.

To determine the overall component placement accuracy $CPA_Q$ in the case of a substrate 5 on which two marks 8 can be measured, used must be made of formula K, which is different from formula C for three marks in that also the absolute value of the anisotropic error has been added to formula K.

In practice it will be preferred to compare the estimated component placement accuracy $CPA_Q$ with the desired component placement accuracy each time, so as to be able to take the necessary measures to ensure that the components will be positioned at the component placement position with the desired degree of accuracy before placement of the components on a substrate actually takes place.

The selection of the marks and also of the component placement position can be optimised on the basis of, for example, "the highest possible positional accuracies" or the "lowest allowable desired positional accuracies". In the latter case, there are possibilities for other optimisation criteria, such as the rate at which components are placed on a substrate, greater freedom of design for a substrate, etc. It is also possible in this connection to divide the substrate into segments, in which case an optimum set of marks is determined for each segment.

The method according to the invention is suitable for assessing the risks of incorrect placement of components in advance, optimising the selection of marks on the substrate, optimising the design of a substrate in dependence on a component placement machine on which the substrate is to be provided with components, etc.

It is also possible to configure the device according to the invention as a separate device, which is separated from the component placement device.

It is also possible to use the method for monitoring the overall component placement process, in which case a user is provided with information about, for example, the accuracy with which each component can be placed.

$$A \qquad Q = \sum_{i=0}^{2}(\alpha_i * P_i) \qquad ; \qquad \sum_{i=0}^{2}\alpha_i = 1$$

$$B \qquad \sigma_Q = \sqrt{\sum_{i=0}^{2}(\alpha_i^2 * \sigma_{P_i}^2)}$$

$$C \qquad CPA_Q = FIX + \sqrt{\sigma_Q^2 + OTH^2}$$

$$D \qquad Q_x - P_{0,x} = \alpha_1 *(P_{1,x} - P_{0,x}) + \alpha_2 *(P_{1,y} - P_{0,y})$$

$$Q_y - P_{0,y} = \alpha_1 *(P_{1,y} - P_{0,y}) - \alpha_2 *(P_{1,x} - P_{0,x}) \qquad ; \qquad \sum_{i=0}^{1}\alpha_i = 1$$

$$E \qquad \sigma_{x,Q} = \sqrt{(1-\alpha_1)^2 * \sigma_{x,P_0}^2 + \alpha_1^2 * \sigma_{x,P_1}^2 + \alpha_2^2 * \sigma_{y,P_0}^2 + \alpha_2^2 * \sigma_{y,P_1}^2}$$

$$\sigma_{y,Q} = \sqrt{\alpha_2^2 * \sigma_{x,P_0}^2 + \alpha_2^2 * \sigma_{x,P_1}^2 + (1-\alpha_1)^2 * \sigma_{y,P_0}^2 + \alpha_1^2 * \sigma_{y,P_1}^2}$$

$$F \qquad \sigma_{x,Q} = \sigma_{y,Q} = \sqrt{((1-\alpha_1)^2 + \alpha_2^2) * \sigma_{P_0}^2 + (\alpha_1^2 + \alpha_2^2) * \sigma_{P_1}^2}$$

$$G \qquad Anis_Q = \beta * \left( (h_{22} - h_{11}) * \begin{pmatrix} F_y \\ F_x \end{pmatrix} + (h_{12} + h_{21}) * \begin{pmatrix} F_x \\ -F_y \end{pmatrix} \right)$$

$$H \qquad Anis_Q = \beta * \left( (s_y - s_x) * \begin{pmatrix} F_y \\ F_x \end{pmatrix} + (\varphi_x - \varphi_y) * \begin{pmatrix} F_x \\ -F_y \end{pmatrix} \right)$$

$$J \qquad |Anis_Q| = \beta * \sqrt{((s_y - s_x)^2 + (\varphi_x - \varphi_y)^2)}$$

$$K \qquad CPA_Q = |Anis_Q| + FIX + \sqrt{\sigma_Q^2 + OTH^2}$$

**Claims**

1. A method for estimating at least one component placement position on a substrate at which a component is to be placed, wherein the component placement position is estimated on the basis of the position of at least one mark on the substrate, **characterized in that**

   - statistical measurement inaccuracies of the marks are determined,
   - after which the positional accuracy of the component placement position on the substrate is estimated on the basis of the measurement inaccuracies of the marks,
   - subsequently the estimated positional accuracy of the component placement position is compared with a predetermined, desired positional accuracy,

- after which it is decided whether or not the component is to be placed on the substrate with the estimated positional accuracy of the component placement position.

2. A method according to claim 1, **characterized in that** at least one other mark is selected if the estimated positional accuracy is lower than the desired positional accuracy, as a result of which the estimated positional accuracy becomes higher than the desired positional accuracy.

3. A method according to any one of the preceding claims, **characterized in that** the estimated positional accuracy is communicated to a user if the estimated positional accuracy is lower than the desired positional accuracy.

4. A method according to any one of the preceding claims, **characterized in that** the component placement position is determined by means of at least one mark located relatively close to the component placement position if the estimated positional accuracy is lower than the desired positional accuracy.

5. A method according to any one of the preceding claims, **characterized in that** said mark is a fiducial mark specifically provided for said determination of position, or part of a pattern of conductors on the substrate on which the component is to be placed.

6. A method according to any one of the preceding claims, **characterized in that** the estimation of the positional accuracy involves at least the use of an error propagation formula.

7. A method according to any one of the preceding claims, **characterized in that** statistically determined inaccuracies that occur upon alignment of a component in a component placement device are taken into account in estimating the positional accuracy.

8. A method according to any one of the preceding claims, **characterized in that** statistically determined inaccuracies that occur upon placement of a component on a substrate are taken into account in estimating the positional accuracy.

9. A method according to any one of the preceding claims, **characterized in that** an estimated anisotropic error is also taken into account in estimating the positional accuracy on the basis of two marks.

10. A method according to any one of the preceding claims, **characterized in that** said marks are selected, with the desired positional accuracy being lower than the estimated positional accuracy for as many different component placement positions at which components are to be placed as possible, whilst the number of marks to be measured is minimal.

11. A method according to any one of the preceding claims, **characterized in that** the position(s) of the mark(s) as well as the component placement positions on the substrate are selected on the basis of the expected inaccuracies in the measurement of marks, the statistically determined inaccuracies that occur upon alignment of a component in a component placement device and the statistically determined inaccuracies that occur upon placement of the component on the substrate, in such a manner that the desired positional accuracy is lower than the estimated positional accuracy for each component placement position.

12. A device suitable for carrying out the method according to any one of the preceding claims, which device comprises an input unit for inputting at least one position of a mark, statistical measurement inaccuracies of each mark, as well as at least one component placement position on a substrate, said device further comprising a processing unit, by means of which the positional accuracy of each component placement position on the substrate can be estimated on the basis of the statistical measurement inaccuracies of the marks, said device further comprising comparing means for comparing the estimated positional accuracy with a predetermined, desired positional accuracy.

FIG. 1

FIG. 2

FIG.3A

FIG.3B

FIG.3C

EP 1 564 792 A2